# EUROPEAN PATENT APPLICATION

(11) **EP 3 974 856 A1**
(43) Date of publication of application: **30.03.2022**
(21) Application number: 20197652.9
(22) Date of filing: 23.09.2020
(51) Int. Cl.: G01R 31/64

(54) **CAPACITOR ARRANGEMENT AND METHOD FOR MONITORING CAPACITOR DEVICE**

(71) Applicant: MARICI Holdings The Netherlands B.V., 3068AX Rotterdam (NL)
(72) Inventor: Majamäki, Jari, 02650 Espoo (FI)
(74) Representative: Kolster Oy Ab

(57) **Abstract**

A capacitor arrangement comprising a capacitor device (20) comprising one or more capacitor elements (21), an optical fibre link (50) arranged at least partly within the capacitor device (20), the optical fibre link having a first end and a second end; and a fault detector (200) configured to monitor the integrity of the optical fibre link (50), and to determine if a fault condition of the capacitor device (20) exists based on the monitored integrity of the optical fibre link (50).

## Description

### FIELD OF THE INVENTION

The present invention relates to a capacitor arrangement, and to a method for monitoring a capacitor device.

### BACKGROUND

An electric power converter, such as an inverter, a rectifier or a combined rectifier/inverter, for example, may have one or more capacitor devices related thereto. One example is a capacitor device connected to DC poles of an electric power converter. Such a capacitor device may comprise one or more capacitors, for example. As a further example, a filter, such as an AC filter, connected to an electric power converter may also include one or more capacitor devices. Such a capacitor device related to an electric power converter may be a separate device or it may be located in the same housing with or within the electric power converter, for example.

Condition of capacitors, such as capacitors related to an electric power converter, can be monitored by measuring the DC voltage of the capacitor and/or each series connected capacitor section if two or more capacitors are connected in series, for instance. Failure of a capacitor may be detected from a drop or crash of the measured DC voltage over the capacitor in question or from an unbalance of the DC voltages of possible series connected capacitors, for example. It is also possible to monitor the condition of a capacitor by measuring or calculating the capacitance of the capacitor, for instance.

A problem related to such condition monitoring of capacitors based on the measurement of the voltage over the capacitor, or of the capacitance thereof, is that when the change and/or unbalance in the capacitor voltage (s) or capacitance is detected, the damage in the capacitor may already be on a catastrophic level and may further result in a capacitor explosion, for example. An explosion of the capacitor may further cause a fire and other significant damage to the surroundings of the capacitor, for instance.

### BRIEF DESCRIPTION

An object of the present invention is thus to provide a method and an apparatus for implementing the method so as to overcome the above problems or at least to alleviate them. The objects of the invention are achieved by an arrangement, and a method which are characterized by what is stated in the independent claims. The preferred embodiments of the invention are disclosed in the dependent claims.

The invention is based on the idea of providing at least one optical fibre link at least partly within a capacitor device, monitoring the integrity of the optical fibre link, and detecting whether a fault condition of the capacitor device exists based on the monitored integrity of the optical fibre link.

An advantage of the solution of the invention is that a developing failure within a capacitor device may be detected early enough to prevent further damage. Moreover, the solution can be implemented in a simple and cost-effective way.

### BRIEF DESCRIPTION OF THE DRAWINGS

In the following the invention will be described in greater detail by means of preferred embodiments with reference to the attached drawings, in which
Figure 1 illustrates an example of an electric system according to an embodiment;
Figure 2 illustrates an example of an inverter according to an embodiment;
Figure 3 illustrates an example of an arrangement according to an embodiment;
Figure 4 illustrates an example of an arrangement according to an embodiment; and
Figure 5 illustrates examples of control arrangements according to embodiments.

### DETAILED DESCRIPTION

The following embodiments are exemplary only. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide further embodiments. Generally, all terms and expressions used herein should be interpreted broadly and they are intended to illustrate, not to restrict, the various embodiments disclosed. The figures may only show components necessary for understanding the various embodiments. The number and/or shape of the various elements, for instance, and generally their implementation, could vary from the examples shown in the figures. The application of the various embodiments described herein is not limited to any specific system, but they can be used in connection with various electric systems. Moreover, the use of the various embodiments described herein is not limited to systems employing any specific fundamental frequency or any specific voltage level, for example.

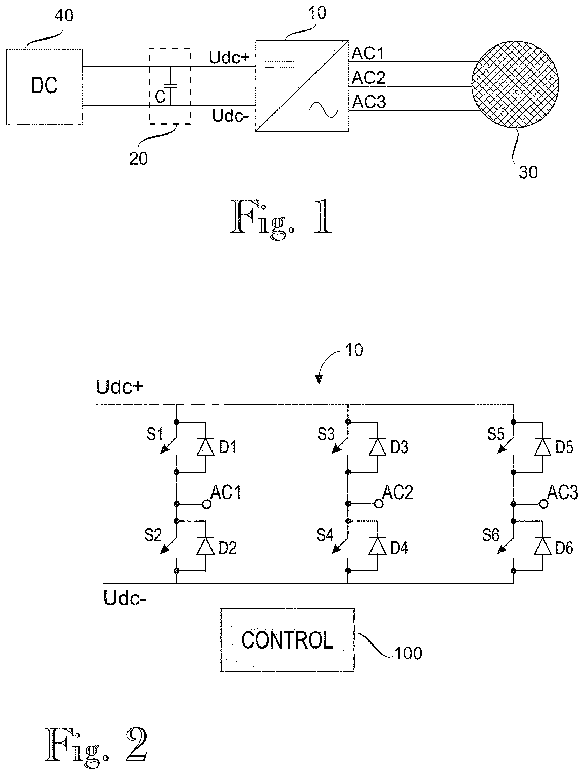

Figure 1 illustrates a simplified example of an electric system. The exemplary system of Figure 1 comprises an electric power converter 10, which in this example is an inverter, which can operate at least as a DC-to-AC converter. Consequently, the exemplary inverter 10 may comprise a suitable electronic device or circuitry that is able to convert direct current to alternating current. The inverter 10 may be configured to operate as a single-stage inverter or as a multi-stage inverter and hence comprise two or more converter stages, for instance. The exemplary converter 10 could also be configured to function both as a rectifier and as an inverter, i.e., to be able to rectify alternating current (AC) into direct current (DC) and convert direct current into alternating current depending on its mode of operation, for example. The circuit configuration of the electric power converter 10 may vary and the converter 10 may generally be any kind of electric power converter comprising an inverter and/or a rectifier. Herein term 'inverter' generally refers to an electronic device or circuitry, for example, that is able to convert direct current to alternating current, and term 'rectifier' generally refers to an electronic device or circuitry, for example, that is able to convert alternating current to direct current. Moreover, instead of three phases, the converter 10 could have another number of AC phases, e.g. one, two or six.

DC poles Udc+, Udc- of the electric power converter 10 may be connected to a DC power system 40, such as a photovoltaic (PV) power generation system comprising one or more photovoltaic panel, for instance. Another example of a possible DC power system 40 is a wind power generation system, such as a wind farm, which may comprise one or more wind generators, driven by one or more wind turbines, for instance. Other type(s) of DC power source(s) or combinations thereof could also be utilized, such as a fuel cell DC power source. Further, AC poles AC1, AC2, AC3 of the electric power converter 10 may be connected to an AC power system 30, such as a public electrical grid or another kind of AC network or an AC load, e.g. in order to supply power from the DC power system 20 to the AC power system 30. The AC connection between the electric power converter 10 and the AC power system 30 may be a three-phase AC connection as illustrated, for example. The electric system may further comprise additional components such as switches, filters and/or fuses, which have not been shown in the figure for the sake of clarity.

The exemplary system of Figure 1 further shows a capacitor device, or a capacitive circuit, 20 connected to the DC poles DC+, DC- of the electric power converter 10. The capacitor device 20 may comprise one or more capacitors C. In case the capacitor device 20 comprises two or more capacitors C, such capacitors may be connected in series and/or in parallel with each other, for instance. The capacitor device 20, or at least a part thereof, could be located within the electric power converter 10, e.g. within a common housing, or be a physically separate element. According to another embodiment, the capacitor device could be connected to the AC poles of the electric power converter. As an example of a possible capacitor device connected to the AC poles of the power converter 10 is a capacitor of an AC filter (not shown in the figures) with one or more capacitive components, such as an LC or an LCL filter, for example. In the exemplary system of Figure 1, such an AC filter with one or more capacitor devices could be connected to the AC poles of the converter 10, for instance.

Figure 2 illustrates an example of an electric power converter 10 according to an embodiment. The exemplary electric power converter of Figure 2 is a two-level three-phase converter that can function both an inverter and also as a rectifier, and the main circuit thereof comprises three switching branches. The number of levels and phases of the electric power converter 10 could vary from the illustrated example. As an example, the electric power converter 10 could be e.g. a multilevel, e.g. three-level, converter, such as an NPC (Neutral Point Clamped) converter or an ANPC (Active Neutral Point Clamped) converter, for example. In the exemplary two-level configuration of Figure 2, the first switching branch comprises semiconductor switches S1 and S2, and their antiparallel diodes D1 and D2, respectively. The second switching branch comprises semiconductor switches S3 and S4, and their antiparallel diodes D3 and D4, respectively. The third switching branch comprises semiconductor switches S5 and S6, and their antiparallel diodes D5 and D6, respectively. The semiconductor switches S1 to S6 may be any kind of controllable power semiconductor switches, such as IGBTs (Insulated-Gate Bipolar Transistor) or FETs (Field-Effect Transistor), which can be controlled according to a modulation or control scheme used, for example. The exemplary converter 10 of Figure 2 further comprises a control arrangement 100, which controls the operation of the converter 10 according to a modulation or control scheme used, for example. For the sake of clarity, no internal control connections between the control arrangement 100 and other components of the converter 10, such as the controllable semiconductor switches S1 to S6, are shown in the figure. The control arrangement 100 may be comprised of one or more physical units and one control arrangement 100 may control a plurality of converters 10.

According to an embodiment, a method for monitoring a capacitor device 20 comprising one or more capacitor elements 21 may comprise providing at least one optical fibre link 50 at least partly within the capacitor device 20, monitoring the integrity of the optical fibre link 50, and determining if a fault condition of the capacitor device exists based on the monitored integrity of the optical fibre link. According to an embodiment, said determining may comprise determining that a fault condition of the capacitor device 20 exists in response to the monitored integrity of the optical fibre link 50 being determined to be damaged. The monitoring of the integrity of the optical fibre link 50 may comprise determining whether the integrity of the optical fibre link 50 is damaged (or not). The integrity of the optical fibre link 50 could be considered as damaged, if the state of the optical fibre link 50 deviates from being unimpaired, for example. In other words, the integrity of the optical fibre link 50 could be determined to be damaged if the integrity of the optical fibre link is broken or at least reduced from a normal condition thereof, for instance. As an example, a typical optical fibre, or an optical fibre cable comprising one or more optical fibres, used for transmitting light, such as light signals, may be made from plastic and/or glass for example. This type of optical fibre may not be very robust against thermal and/or mechanical damage. Then by arranging optical fibre link comprising one or more optical fibres at least partly inside a capacitor device comprising one or more capacitor elements, a deformation and/or heating of the one or more capacitor elements can be detected as the optical fibre link inside the capacitor device becomes damaged as a result of the deformation and/or heating of the one or more capacitor elements. Then, by monitoring the integrity of the optical fibre link 50, a possible fault condition of the capacitor device 20 can be detected. According to an embodiment, the integrity of the optical fibre link may be monitored by sending one or more light signals (pulses) into the optical fibre link 50 by means of an optical transmitter connected to one (first) end of the optical fibre link, and detecting light signals arriving from the optical fibre link by means of an optical receiver connected to another (second) end of the optical fibre link. Then, according to an embodiment, it may be determined that the integrity of the optical fibre link 50 is damaged in response to the one or more light signals sent by the optical transmitter into the optical fibre link failing to be received by the optical receiver from the optical fibre link and/or in response to an attenuation of the one or more light signals sent by the optical transmitter into the optical fibre link and received by the optical receiver from the optical fibre link exceeding a predetermined threshold, for example. According to an embodiment, a continuous light signal may be sent into the optical fibre link 50. According to another embodiment, a plurality of light signals at predetermined time intervals may be sent into the optical fibre link 50. The form of the one or more light signals used for the monitoring may be determined according to system characteristics and may depend on the type of the optical fibre link 50 used, for example. According to an embodiment, e.g. when the capacitor device 20 is connected to an electric power converter 10, the electric power converter 10 may be controlled to stop power conversion operation, either immediately or after a predetermined delay, in response to the determining that a fault condition of the capacitor device 20 exists. Instead or additionally, it is possible to output or send a warning or an alert to a user or an operator of the electric power converter 10 or to some higher level control system in response to the determining that a fault condition of the capacitor device 20 exists, for example.

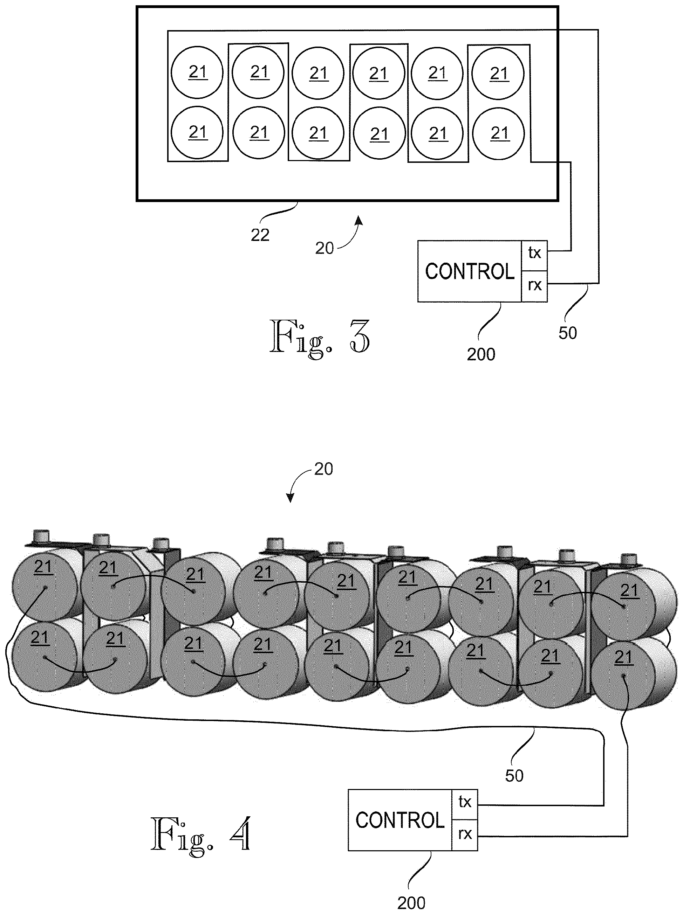

Figure 3 illustrates an example of an arrangement according to an embodiment. The exemplary capacitor arrangement comprises a capacitor device 20 comprising one or more capacitor elements 21. The one or more capacitor elements 21 may each comprise one or more capacitors. Electrical connections between the capacitor elements 21 are not shown in the figure for the sake of clarity. The capacitor device 20 may comprise a suitable housing or an enclosure 22 in which the one or more capacitor elements 21 are located as illustrated. Generally, a capacitor or a capacitor element 21 can be made e.g. essentially cylindrical in shape as in the example illustrated. However, a capacitor element 21 could also have any other shape, e.g. it could be squeezed to a flatter shape, for instance. There may also be a hole through the centre of a cylindrical capacitor, for example. A capacitor element 21 could be also wound or stacked to a flat shape from the beginning, for example. The exemplary arrangement further comprises an optical fibre link 50 arranged at least partly within the capacitor device 20, the optical fibre link 50 having a first end and a second end. According to an embodiment, the optical fibre link 50 may comprise one or more optical fibres, which may be connected in series and/or in parallel with each other, for example. The exemplary arrangement further comprises fault detection means (fault detector) 200 configured to monitor the integrity of the optical fibre link 50, and to determine if a fault condition of the capacitor device 20 exists based on the monitored integrity of the optical fibre link 50. The fault detection means 200 may be configured to determine whether the integrity of the optical fibre link 50 is damaged (or not) during the monitoring of the integrity of the optical fibre link 50 or such determination could be performed by one or more further entities, for instance. According to an embodiment, the fault detection means 200 may be configured to determine that a fault condition of the capacitor device 20 exists in response to the monitored integrity of the optical fibre link 50 being determined to be damaged. According to an embodiment, the fault detection means 200 may be configured to determine that the integrity of the optical fibre link 50 is damaged if the link is broken, i.e. the optical fibre link 50 cannot convey light signals therethrough. According to an embodiment, the fault detection means 200 may be configured determine that the integrity of the optical fibre link 50 is damaged if the optical fibre link 50 attenuates a light signal travelling therethrough more than a predetermined threshold, for example.

According to an embodiment, the fault detection means 200 may comprise an optical transmitter tx and an optical receiver rx. According to an embodiment, the optical transmitter tx is connected, either directly or indirectly, to the first end of the optical fibre link 50, and the optical receiver rx is connected, either directly or indirectly, to the second end of the optical fibre link 50 as illustrated in Figure 3. According to an embodiment, the optical transmitter tx may be configured to send one or more light signals into the optical fibre link 50, and the optical receiver rx may be configured to detect light signals arriving from the optical fibre link 50. According to an embodiment, the fault detection means 200 may be configured to determine that the optical fibre link 50 is damaged in response to the one or more light signals sent by the optical transmitter tx into the optical fibre link 50 failing to be received by the optical receiver rx from the optical fibre link 50, and/or in response to an attenuation (transmission loss) of the one or more light signals sent by the optical transmitter tx into the optical fibre link 50 and received by the optical receiver rx from the optical fibre link 50 exceeding a predetermined threshold. According to an embodiment, the optical transmitter tx may be configured to send a continuous light signal into the optical fibre link 50. According to another embodiment, the optical transmitter tx may be configured to send light signals at predetermined time intervals into the optical fibre link 50.

Generally, the type(s) of the one or more optical fibres, or the type of an optical fibre cable comprising one or more optical fibres, of the optical fibre link 50 may be selected according to system specific criteria. As an example, a plastic material and/or glass material fibre(s) may be used. Moreover, a multi-mode fibre and/or single-mode fibre may be used, for example. According to an embodiment, the at least one optical fibre of the optical fibre link 50 may have a predetermined, or known, melting temperature. By suitably selecting an optical fibre having a desired predetermined, or known, melting temperature, the failure of the capacitor device can be detected at a desired temperature thereof, for instance.

According to an embodiment, the optical fibre link 50 may be arranged in direct contact and/or indirect (e.g. via one or more mediums) contact with the one or more capacitor elements 21 within the capacitor device 20. According to an embodiment, such a (direct or indirect) contact may be configured to provide a (direct or indirect) physical and/or thermal coupling of the optical fibre link 50 with the one or more capacitor elements 21 within the capacitor device 20. Thus, according to an embodiment, the optical fibre link 50 may be arranged to be, directly or indirectly, thermally coupled with the one or more capacitor elements 21 within the capacitor device 20. A direct thermal coupling can be arranged as a solid to solid contact, i.e. such that e.g. no gas or other substance possibly weakening the thermal coupling is allowed between the optical fibre link 50 and the one or more capacitor elements 21. As in some cases it may not be possible or technically feasible to arrange the optical fibre link 50 in direct physical contact with the one or more capacitor elements 21, e.g. a solid medium, such as a potting compound, could be used to provide sufficient indirect thermal coupling between the optical fibre link 50 and the one or more capacitor elements 21, for instance.

If the optical fibre link 50 is in direct (physical) contact, i.e. touching, the one or more capacitor elements 21 within the capacitor device 20, the deformation and/or heating of the one or more capacitor elements may be detected faster. In addition, or alternatively, the optical fibre link 50 may be wound at least partly around the one or more capacitor elements 21 within the capacitor device 20. In the example of Figure 3, one example of wounding the optical fibre link 50 around the capacitor elements 21 is shown. However, other ways of wounding the optical fibre link 50 around the capacitor elements 21 are possible. As an example, the optical fibre link 50 could be wound at least once fully each one of the one or more capacitor elements 21 within the capacitor device 20. According to an embodiment, the optical fibre link 50 may be arranged to run through at least one of the one or more capacitor elements 21. Figure 4 shows an example of a capacitor arrangement according to an embodiment in which the capacitor elements are each provided with a through-hole and the optical fibre link 50 runs through each of the one or more capacitor elements 21 via the respective holes thereof within the capacitor device 20. While in the example of Figure 4 the optical fibre link 50 runs once through each of the one or more capacitor elements 21 via the respective holes thereof, the optical fibre link 50 could be arranged to run more than once through each of the one or more capacitor elements 21 via the respective holes thereof.

According to another embodiment, the one or more capacitor elements 21 may be potted inside the capacitor device 20 with a potting compound, and the optical fibre link 50 may be arranged at least partly within the potting compound in the capacitor device. As an example, such potting could be implemented by filling the housing or enclosure of the capacitor device 20 wholly or at least partly with the potting compound such that the one or more capacitor elements 21 are wholly or at least partly submerged within the potting compound. Some possible examples of the potting compound, or its blend components, include epoxy resin and urethane. However, the potting could be implemented by using any suitable potting compound possibly depending on the characteristics of the system, for instance. An advantage provided by the potting is that the potting compound may provide for an enhanced indirect contact of the optical fibre link 50 with the one or more capacitor elements 21 and thus the deformation and/or heating of the one or more capacitor elements 21 may be detected faster. A failure of a capacitor element 21 usually causes expansion of the capacitor element. Such expansion will cause the optical fiber link 50 embedded in the potting compound to stretch and fail indicating a fault just like melting of the cable. Also, the potting compound may convey heat from a failing capacitor element 21 faster to the optical fiber link 50 embedded in the potting compound.

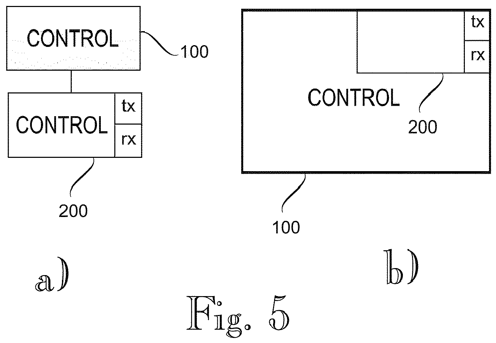

According to another embodiment, a converter system may be provided comprising an electric power converter 10, and a capacitor arrangement according to any one of the embodiments described herein, wherein the capacitor device 20 is connected to the electric power converter 10, and control means configured to control the electric power converter 10 to stop power conversion operation in response to the fault detection means determining that a fault condition of the capacitor device 20 exists. E.g. in case of an inverter, the stopping of power conversion operation could include stopping the modulation performed by the inverter. Such control means could be implemented separately by means of suitable control arrangement capable of controlling the electric power converter 10 or by e.g. by the control arrangement 100 of the converter 10. In the latter case the control arrangement 100 of the converter 10 may be connected to the fault detection means 200 in order to be able to receive the fault condition information from the fault detection means, as exemplified in alternative a) of Figure 5. In this alternative the fault detection means 200 may be implemented separately e.g. within the capacitor device 20. Alternatively, as exemplified in alternative b) of Figure 5, the fault detection means 200 may be implemented within the control arrangement 100 of the converter 10, e.g. as one or more functional units thereof. According to an embodiment, the fault detection means 200 and/or the control arrangement 100 of the converter 10 may be configured to output or send a warning or an alert to a user or an operator of the electric power converter 10 and/or to some higher level control system in response to the fault detection means determining that a fault condition of the capacitor device 20 exists, for example.

Generally, e.g. the fault detection means 200 and/or the control arrangement 100 according to any one of the embodiments, or a combination thereof, as well as any possible further control elements provided to implement any of the embodiments, can be implemented as one unit or as two or more separate units that are configured to implement the functionality of the various embodiments. Here the term 'unit' refers generally to a physical and/or logical entity, such as a physical device or a part thereof or a software routine. The fault detection means 200 and/or the control arrangement 100 according to any one of the embodiments, or a combination thereof, as well as any possible further control elements provided to implement any of the embodiments, may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a CPU control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system, which may provide system services to a computer program written with the program instructions. The computer or other apparatus implementing the functionality of the various embodiments, or a part thereof, may further comprise suitable input means for receiving measurement and/or control data, for example, and output means for outputting control data, for example. It is also possible to use a specific integrated circuit or circuits, such as application-specific integrated circuits (ASIC), and/or programmable logic devices (PLD), such as a field-programmable gate array (FPGA), and/or discrete electric components and devices for implementing the functionality according to any one of the embodiments.

The various embodiments can be implemented in existing system elements or by using separate dedicated elements or devices in a centralized or distributed manner. Present electric power converter devices, for example, can comprise programmable logic devices, or processors and memory that can be utilized in the functions according to the embodiments. Thus, at least some modifications and configurations required for implementing an embodiment in existing converters, for example, may be performed as software routines, which may be implemented as added or updated software routines. If at least part of the functionality of an embodiment is implemented by software, such software can be provided as a computer program product comprising computer program code which, when run on a computer, causes the computer or a corresponding arrangement to perform the functionality according to the embodiment. Such a computer program code may be stored or generally embodied on a computer readable medium, such as a suitable memory, e.g. a flash memory or an optical memory, from which it is loadable to the unit or units executing the program code. In addition, such a computer program code implementing an embodiment may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

## Claims

1. A capacitor arrangement comprising:
a capacitor device (20) comprising one or more capacitor elements (21);
an optical fibre link (50) arranged at least partly within the capacitor device (20), the optical fibre link having a first end and a second end; and
fault detection means (200) configured to monitor the integrity of the optical fibre link (50), and to determine if a fault condition of the capacitor device (20) exists based on the monitored integrity of the optical fibre link (50).

2. An arrangement as claimed in claim 1, wherein the fault detection means (200) are configured to determine that a fault condition of the capacitor device (20) exists in response to the integrity of the optical fibre link (50) being determined to be damaged.

3. An arrangement as claimed in claim 1 or 2, wherein the fault detection means (200) comprise:
an optical transmitter (tx) connected to the first end of the optical fibre link (50) and configured to send one or more light signals into the optical fibre link; and
an optical receiver (rx) connected to the second end of the optical fibre link (50) and configured to detect light signals arriving from the optical fibre link,
wherein the fault detection means (200) are configured to determine that the integrity of the optical fibre link (50) is damaged in response to the one or more light signals sent by the optical transmitter (tx) into the optical fibre link failing to be received by the optical receiver (rx) from the optical fibre link and/or in response to an attenuation of the one or more light signals sent by the optical transmitter (tx) into the optical fibre link (50) and received by the optical receiver (rx) from the optical fibre link exceeding a predetermined threshold.

4. An arrangement as claimed in claim 3, wherein the optical transmitter (tx) is configured to send a continuous light signal into the optical fibre link (50).

5. An arrangement as claimed in claim 3, wherein the optical transmitter (tx) is configured to send light signals at predetermined time intervals into the optical fibre link (50).

6. An arrangement as claimed in any one of claims 1 to 5, wherein the optical fibre link (50) comprises at least one optical fibre.

7. An arrangement as claimed in claim 6, wherein the at least one optical fibre has a predetermined melting temperature.

8. An arrangement as claimed in any one of claims 1 to 7, wherein the optical fibre link (50) is arranged in direct contact and/or indirect contact with the one or more capacitor elements (21) within the capacitor device (20).

9. An arrangement as claimed in any one of claims 1 to 8, wherein the optical fibre link (50) is wound at least partly around the one or more capacitor elements (21) within the capacitor device (20).

10. An arrangement as claimed in any one of claims 1 to 9, wherein the optical fibre link (50) is arranged to run through at least one of the one or more capacitor elements (21) within the capacitor device (20).

11. An arrangement as claimed in any one of claims 1 to 10, wherein the one or more capacitor elements (21) are potted inside the capacitor device (20) with a potting compound, wherein the optical fibre link (50) is arranged at least partly within the potting compound in the capacitor device (20).

12. A converter system, comprising:
an electric power converter (10);
an arrangement as claimed in any one of claims 1 to 11, wherein the capacitor device (20) is connected to the electric power converter (10); and
control means (100) configured to control the electric power converter (10) to stop power conversion operation in response to the fault detection means (200) determining that a fault condition of the capacitor device (20) exists.

13. A converter system as claimed in claim 12, wherein the electric power converter (10) comprises an inverter, wherein the capacitor device (20) is connected to DC poles of the inverter or to AC poles of the inverter.

14. A method for monitoring a capacitor device comprising one or more capacitor elements, the method comprising:
providing at least one optical fibre link (50) at least partly within the capacitor device (20), the optical fibre link having a first end and a second end;
monitoring the integrity of the optical fibre link (50); and
determining if a fault condition of the capacitor device (20) exists based on the monitored integrity of the optical fibre link (50).

15. A method as claimed in claim 14, wherein the step of determining comprises determining that a fault condition of the capacitor device (20) exists in response to the monitored integrity of the optical fibre link (50) being determined to be damaged.
